# EUROPEAN PATENT APPLICATION

(11) **EP 4 589 630 A1**
(43) Date of publication of application: **23.07.2025**
(21) Application number: 24152038.6
(22) Date of filing: 16.01.2024
(51) Int. Cl.: H01J 37/28, H01J 37/20, H01J 37/26

(54) **IMPROVED SCANNING ELECTRON MICROSCOPE AND METHOD OF USING THE SAME**

(71) Applicant: FEI Company, Hillsboro, OR 97124-5793 (US)
(72) Inventor: TROJEK, Jan, Czechia (CZ); UNCOVSKY, Marek, Czechia (CZ); VYSTAVEL, Tomas, Czechia (CZ); CAHA, Miroslav, Czechia (CZ); ZAKOPAL, Petr, Czechia (CZ)
(74) Representative: Boult Wade Tennant LLP

(57) **Abstract**

In accordance with the present invention, there is provided a scanning electron microscope comprising: an electron source; a sample holder for holding a sample to be analysed; a projector; and a first detector. Each of the electron source and the sample holder are arranged upon an optical axis of the scanning electron microscope. The projector is moveable between a first, operational position in which the projector is located along the optical axis downstream of the sample holder and between the sample holder and the first detector, and a second, retracted position in which the projector is located away from the optical axis. There is also provided a method of imaging a sample with the scanning electron microscope.

## Description

### Field

The claimed invention relates to a scanning electron microscope (SEM) that can achieve higher resolution on-axis diffraction imaging.

### Background

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" apparatus (such as a FIB-SEM, for example), which additionally employ a "machining" Focused Ion Beam (FIB), allowing supportive activities such as ion-beam milling or lon-Beam-Induced Deposition (IBID), for example. The skilled person will be familiar with the different species of charged particle microscopy.

In a SEM, irradiation of a specimen by a scanning electron beam causes emanation of "auxiliary" radiation from the specimen, in the form of secondary electrons, backscattered electrons, X-rays and photoluminescence (infrared, visible and/or ultraviolet photons). One or more components of this emanating radiation is/are then detected and used for image accumulation purposes, and/or spectroscopic analysis (as in the case of EDX (Energy-Dispersive X-Ray Spectroscopy), for example). If the sample is sufficiently thin, then transmitted electrons can also be detected and this is referred to as SEM-based scanning transmission electron microscopy (SEM-based STEM). In an SEM, the scanning electron beam typically has an energy ranging from 0.2 keV to 30 keV.

In a TEM, an electron beam used to irradiate the specimen is chosen to be of a high enough energy to penetrate the specimen (which, to this end, will generally be thinner than in the case of a SEM specimen). The flux of transmitted electrons emanating from the specimen can then be used to create an image, or produce a spectrum (as in the case of Electron Energy-Loss Spectroscopy, EELS). If such a TEM is operated in scanning mode, i.e. in TEM-based STEM, then the image/spectrum in question will be accumulated during a scanning motion of the irradiating electron beam. In a TEM, the electron beam typically has an energy ranging from 60 to 300 keV.

In TEM-based STEM, the electron beam typically has a much higher energy thereby leading to lower chromatic aberration and lower spherical aberration compared to SEM-based STEM. However, in SEM-based STEM, thin STEM samples can be prepared in situ (i.e. inside the SEM chamber) from a bulk sample.

It is known that TEM can advantageously switch between its normal imaging mode and diffraction mode to analyse defects and crystal structures. Diffraction techniques within SEM typically relate to electron backscatter techniques. The concept of on-axis transmission diffraction in SEM is still relatively new. Transmission diffraction techniques within SEM include ptychography and transmission Kikuchi diffraction (TKD). Recently, pixelated detectors have provided new possibilities for detecting on-axis transmission diffraction patterns with SEM. However, such techniques are limited by the resolution that can be achieved.

### Summary

In accordance with a first aspect of the invention, there is provided a scanning electron microscope comprising: an electron source; a sample holder for holding a sample to be analysed; a projector; and a first detector. Each of the electron source and the sample holder being arranged upon an optical axis of the scanning electron microscope. The projector is moveable between a first, operational position in which the projector is located along the optical axis downstream of the sample holder and between the sample holder and the first detector, and a second, retracted position in which the projector is located away from the optical axis.

The optical axis of the SEM is the axis that the sample holder and electron source are arranged upon i.e. aligned with/co-axial with/centred with. In use, the primary electron beam produced by the electron source is emitted from the electron source along the optical axis of the SEM. The reference to upstream/downstream throughout this specification refers to the path of the electron beam through the SEM. The path of the electrons being from the electron source towards the sample holder such that, for example, the electron source is upstream of the sample holder.

A component being arranged or located along the optical axis refers to the optical axis intersecting that component, preferably, the component being centred with/co-axial with/aligned with the optical axis.

Projectors are known in TEMs to magnify the diffracted beam onto the detector and increase the resolution of the diffractogram produced. However, known projectors within TEMs typically contain multiple magnetic lenses with significant weight and a total length of about 50 cm thereby preventing their use in known SEM systems where available space between a sample holder and detector is typically less than 4 cm.

In the claimed invention, by incorporating a projector that can be located in a first, operational position along the optical axis of the SEM, downstream of the sample holder and between the sample holder and the first detector, the projector can improve resolution of the on-axis transmission diffraction patterns for thin samples. Such thin samples may have a thickness between 1 atom thick to hundreds of nanometres thick. However, as the projector can be moved from this first, operational position where it is along the optical axis of the SEM to a second, retracted position, where it is away from the optical axis of the SEM, the scanning electron microscope can still be used to image thicker samples using backscattered or secondary electron detectors upstream of the sample holder. Indeed, when the projector is in the second, retracted position, there is sufficient space along the optical axis of the SEM so that thicker samples can be accommodated on the sample holder and imaged using the BSE or SE detectors of the SEM.

When the projector is in the first, operation position, the sample holder, the projector and the first detector are located along the optical axis of the SEM such that transmitted electrons emanating from the sample would pass through the projector before being transmitted to the first detector. The first detector can therefore detect transmission on-axis diffraction (electrons transmitted through and diffracted by the sample) and the projector can increase the magnification of the diffraction pattern on the first detector. As discussed above, the reference to "located along" the optical axis in this context refers to the optical axis bisecting or, preferably, being centred with/co-axial with the sample holder, the projector, the first detector and the electron source. When the projector is in the first, operational position, the projector may be located directly between the sample holder and the first detector so that there are no other intervening components therebetween.

In the second, retracted position, the projector is located away from the optical axis of the SEM. The projector is offset from the optical axis of the SEM such that transmitted electrons emanating from the sample would not pass through the projector. This enables thicker samples to be imaged as, when the projector is position away from the optical axis of the SEM, there is greater space along the optical axis between the sample holder and detector to accommodate a thicker sample.

The SEM may comprise one or more second detector(s). The second detector(s) may be back-scattered electron (BSE) detector and/or secondary electron (SE) detector . BSE and SE detectors and their arrangement within the SEM is known in the art. As is known in the art, the BSE detector and/or the SE detector may be positioned upstream of the sample holder. The BSE detector may be an annular detector arranged concentrically with the optical axis of the SEM. The SE detector may be arranged offset with the optical axis of the SEM. In such an embodiment, when the projector is located in the second, retracted position, thicker samples can be imaged in an imaging mode of the SEM where backscattered and/or secondary electrons are detected by the second detector(s).

The first detector may be coupled to the projector and moveable with the projector as the projector moves between its first, operational position and second, retracted position. The first detector may be fixed relative to the projector and spaced apart from the projector such that the projector is between the sample holder and the first detector when the projector is in the first, operational position. The first detector may be spaced apart from the projector such that the first detector is downstream of the projector. The first detector may be spaced apart from the projector in a direction parallel to or along an optical axis of the projector referred to herein as the projector optical axis. The projector optical axis being the axis which the electron beam travels along through the projector, typically through the centre of the projector.

The first detector may be fixed relative to the projector such that, when the projector is in the first, operational position, the projector is between the sample holder and the first detector and the optical axis of the SEM intersects both the first detector and the projector. In other words, the first detector may overlap the projector and be downstream of the projector such that electrons passing through the projector impact the first detector. Such a configuration means that, when the projector is in the first, operational position, the first detector can detect transmitted electrons emanating from the sample. The first detector may be fixed relative to the projector so that the active area of the detector (i.e. the area of the first detector that is configured to receive electrons) is always aligned with the projector optical axis. When the projector is in the second, retracted position, the first detector may be still aligned with the projector so that the active area of the detector is aligned with (i.e. overlaps with, preferably centred with) the projector optical axis but the projector (and so the first detector) may be located away from the optical axis of the SEM. This means that the optical axis of the SEM does not intersect the projector or the first detector. Moving both the projector and the first detector away from the optical axis provides greater space for thicker samples to be accommodated. The SEM can then operate in its normal imaging mode whereby thicker samples are imaged based on secondary electrons and backscattered electrons emanating from the sample. In such an arrangement, second detector(s), such as BSE or SE detectors may be used when imaging the thicker sample, as is known in the art. By way of example, such a thicker sample may have any thickness providing that it can geometrically fit onto the sample holder of the SEM in accordance with typical use of a SEM. For example, the thicker sample may have a thickness up to several cm.

The projector may be movable between the first, operational position and the second, retracted position in a plane orthogonal to the optical axis of the SEM. The projector may be moveable linearly between the first, operational position and the second, retracted position.

The scanning electron microscope may further comprise an arm operable to move the projector between the first, operational position and the second, retracted position. The arm may be configured to move in a plane orthogonal to the optical axis of the SEM when moving the projector between the first, operational position and the second, retracted position. The arm may be configured to move linearly when moving the projector between the first, operational position and the second, retracted position.

The arm may extend longitudinally in a plane orthogonal to the optical axis of the SEM between a first end and a second end, wherein the first end is coupled to the projector. The arm may be of fixed length and may be rigid such that it does not deform in use. The arm may be configured to move linearly when moving the projector between the first, operational position and the second, retracted position. The longitudinal axis referred to herein may be the axis along the length of the arm and along which the arm moves. The longitudinal axis may be perpendicular to the optical axis of the SEM.

The arm may be configured to support the projector. The arm may be configured to support both the projector and the first detector. The first end of the arm may be coupled to both the projector and the first detector. The first end of the arm may hold both the first detector and the projector such that the first detector is fixed relative to the projector. The first end of the arm may comprise a holder configured to hold the first detector and the projector such that the first detector is fixed relative to the projector. The holder may hold (i.e. retain and support) the first detector spaced apart from the first detector in a direction parallel to or along the optical axis of the projector. The holder may hold the first detector fixed relative to the projector, in particular the holder may hold the first detector downstream of the projector.

Optionally the scanning electron microscope further comprises a slider configured to transmit linear motion to the arm. The slider may be coupled to the second end of the arm. The slider may comprise a movable carriage and a track. The second end of the arm may comprise a mount configured to couple the arm to the movable carriage. The second end of the arm may be fixed relative to the movable carriage such that linear movement of the movable carriage within the track causes linear movement of the arm.

The projector and/or the first detector may be cooled. Cooling the projector and first detector prevents the built up of heat that could otherwise result in increased noise and reduced stability thereby degrading the performance of the projector and first detector. In particular, the arm operable to move the projector between the first and second positions may be thermally coupled to the projector and/or the first detector and configured to cool the projector and/or the first detector. The projector and the first detector may be thermally coupled together. The arm may configured to thermally conduct heat away from the projector and/or the first detector. The arm may comprise a thermally conductive material, such as copper. The arm may be configured to thermally conduct heat from the projector and/or the first detector at its first end along its length to the second end of the arm. The second end of the arm may comprise a cooling component configured to cool the second end of the arm. In such an arrangement, the arm may thermally couple the projector and/or the first detector to the cooling component. Cooling the second end of the arm results in a thermal gradient between the first end of the arm and the second end of the arm to conduct heat away from the projector and/or the first detector. The cooling component may be an active cooling component such that the second end of the arm is actively cooled by the cooling component. Such an active cooling component may employ pumps or fans for the circulation of coolant therein. The cooling component may be, for example, a heat exchanger, a heat sink or a closed-loop system that recirculates coolant therein.

The arm may comprise one or more rods extending between the first and second ends of the arm. In other words, the one or more rod(s) may extend along the longitudinal axis of the arm. The rods may be rigid and of fixed length. The rod(s) may be hollow i.e. have cavities therein. The cavities within the rod(s) may be configured to receive coolant, for example water. The rod(s) may be thermally coupled to the projector and/or the first detector via the first end of the arm. The rods may thermally couple the projector and/or the first detector to the cooling component. Optionally, the one or more rod(s) may comprise one or more heat pipes. The portion of the one or more heat pipes proximal to the second end of the arm may be actively cooled by the cooling component. Providing a projector with a corresponding detector (the first detector) that are both retractable and cooled is particularly advantageous for performing on-axis transmission diffraction imaging in a SEM.

The scanning electron microscope may comprise a housing having a first housing portion defining a first chamber therein within which the first detector, sample holder, projector, objective, condenser module and electron source (and second detector when present) are located. The first chamber may be under vacuum. The arm may extend through one or more port(s) within the first housing portion so that the first end of the arm (and holder where present) is positioned within the first chamber and the second end of the arm is positioned outside the first chamber. The second end of the arm may be coupled to the slider and the slider may be positioned outside the first chamber. In an arrangement where the cooling component is employed, the cooling component may also be positioned outside the first chamber. The housing may further comprise a second housing portion coupled to the first housing portion via a vacuum flange containing the one or more ports. The second housing portion may define a second chamber containing the second end of the arm and, where present, the slider and cooling component. The second chamber may be under vacuum.

The objective generates a magnetic field referred as an objective lens that may optionally be an electromagnetic immersion lens.

The projector may comprises one or more projector lens(es). The projector lens(es) may be referred to herein as projective lens(es). Optionally the one or more projector lens(es) may be electromagnetic lenses. Optionally, the one or more projector lens(es) may be multipole lenses. Optionally, the one or more projector lens(es) may be round lenses. In particular, the projector may comprise, more specifically consist of, a single lens (i.e. one lens) thereby minimising the weight, size and cost of the projector, which is particularly important for incorporation into the SEM. In particular, the single lens may be an electromagnetic lens. Minimising the size is of particular importance, since in the SEM system, the space within the chamber that houses the sample (referred to as the first chamber herein) is limited thereby restricting the height of the projector. The claimed invention achieves enhanced optical performance in the SEM without compromising on size, weight and cooling capability. In contrast, in a TEM, there are no size or weight restrictions on the projector, since the projector would be placed outside the chamber housing the sample.

In an embodiment where the projector has a single lens, the single lens may be an electromagnetic multipole lens. In such an embodiment, the projector lens may have a shell that houses a projector lens coil arranged circumferentially around the projector optical axis. The projector lens may have an upper projector pole piece and a lower projector pole piece separated by a projector gap, optionally wherein the upper projector pole piece and the lower projector pole piece comprise a cylindrical inlet portion upstream of a frustoconical portion, further optionally wherein the frustoconical portion of the lower projector pole piece has a greater height and/or is inclined at a greater angle than the frustoconical portion of the upper projector pole piece.

The projector may be used with a projector coil excitation of, for example 1000-2000 Ampere-turns, preferably 1500-2500 Ampere-turns.

The first detector may be a pixelated detector. The pixelated detector may comprise a pixel grid having a plurality of pixels. The use of a projector within an SEM having a pixelated detector is particularly advantageous, since pixelated detector bring a need of magnifying the diffracted beam to the detector to increase the resolution of the diffractogram. The combination of the projector and pixelated detector within an SEM facilitate advanced SEM-based STEM diffraction techniques including ptychography, strain analysis, micro-ED and TKD. As such pixelated detectors generate a significant amount of heat, providing a mechanism for both cooling and retracting the projector and the first detector is particularly advantageous.

In accordance with the present invention, there is also provided a method of imaging a sample with a scanning electron microscope, the scanning electron microscope comprising an electron source, a sample holder, a projector and a first detector, wherein the electron source and the sample holder are arranged upon an optical axis of the scanning electron microscope, the method comprising: placing a first sample on the sample holder of the microscope; moving the projector to a first, operational position from a second, retracted position; scanning a first electron beam generated by the electron source along the first sample to generate a first image; and projecting the first image onto the first detector using the projector in its first, operational position. In the first, operational position the projector is located along the optical axis downstream of the sample holder and between the sample holder and the first detector, and in the second, retracted position the projector is located away from the optical axis. The first image is an electron diffraction pattern formed by electrons transmitted through and diffracted by the sample.

The step of projecting the first image onto the first detector involves magnifying the image onto the first detector i.e. spreading out the electrons that have been transmitted through and diffracted by the sample.

The teaching above in respect of features of the scanning electron microscope equally applies to this method.

As discussed above, the scanning electron microscope may further comprise a second detector, wherein the second detector is arranged upstream of the sample holder, wherein the second detector is configured to detect back scattered and/or secondary electrons emanating from the sample. The method may further comprise: replacing the first sample with a second sample on the sample holder of the microscope; moving the projector from the first, operational position to the second, retracted position; scanning a second electron beam generated by the electron source along the second sample to generate back scattered and/or secondary electrons; and receiving the back scattered and/or secondary electrons at the second detector to form an image of the second sample.

The second sample may be thicker than the first sample.

For example, the first sample may have a thickness from 1 atom thick up to 1×10⁻⁷ m thick. The second sample may have a thickness that is only limited by the geometric constraints of the sample holder. For example, the second sample may have a thickness up to 1×10⁻¹ m.

Accordingly, this method enables using the SEM to image thinner samples in on-axis transmission diffraction imaging mode with improved resolution due to the projector and imaging thicker samples in normal SEM mode (using back scattered and secondary electrons).

Alternatively, the method may not involve the step of replacing the first sample with the second sample and the first sample may be imaged first using the projector and the first detector and subsequently using the second detector.

### Brief description of Figures

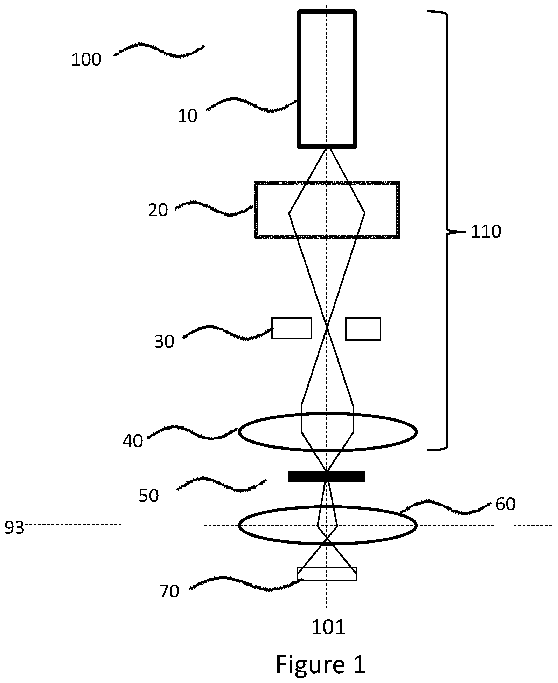

Figure 1 is a schematic diagram of the optical components of the SEM 100 of the claimed invention and the path of the electron beam therethrough, the SEM 100 having an electron optical column 110, a sample holder 50, a projector 60 and a first detector 70, where the projector 60 is arranged in a first, operational position.

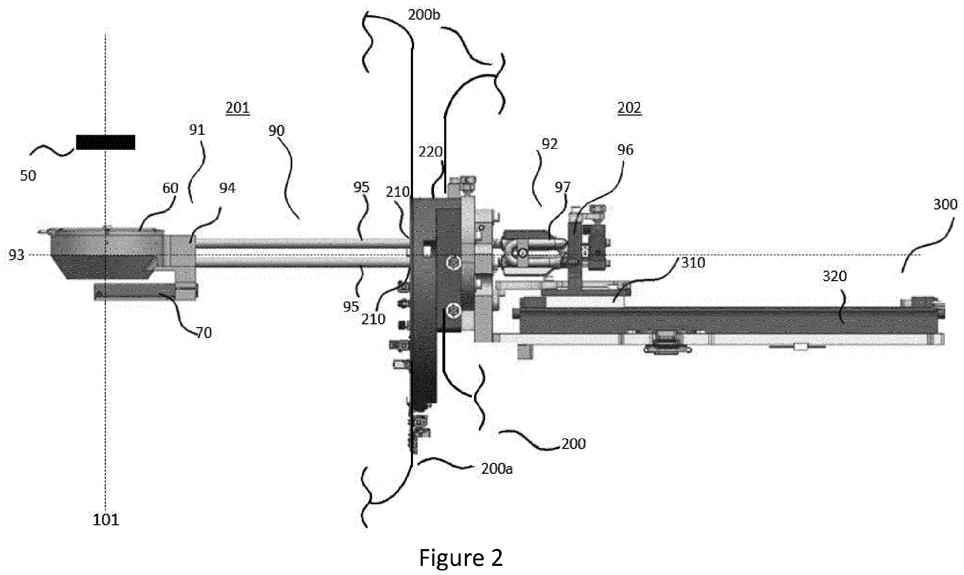

Figure 2 is a schematic diagram of a part of the SEM 100 of the claimed invention where the housing 200 has been partly removed from view and the projector 60 is in its first, operational position. Figure 2 includes the slider mechanism 300 and the arm 90 of the SEM 100 for moving the projector 60 between its first, operational position and its second, retracted position. The electron optical column 110 of the SEM 100 shown in Figure 1 have been omitted from Figure 2 for clarity.

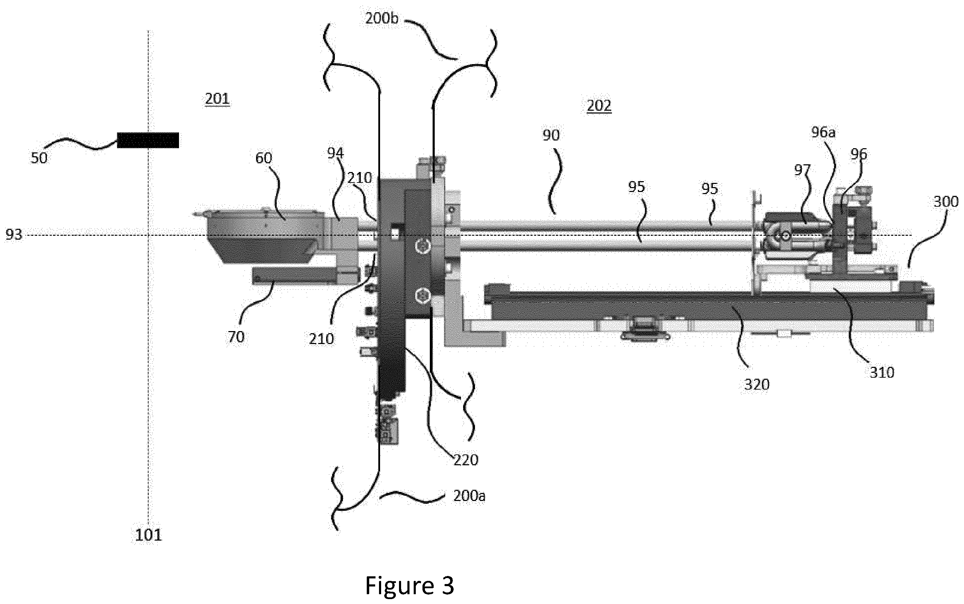

Figure 3 is similar to Figure 2 except that the projector 60 is in its second, retracted position.

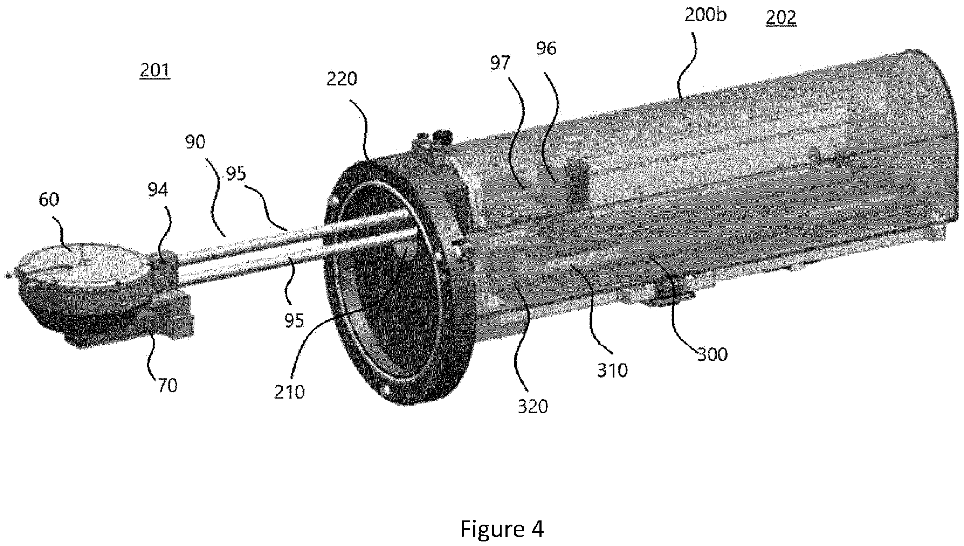

Figure 4 is a perspective view of the SEM 100 of the claimed invention with the projector 60 in its second, retracted position. Figure 4, similarly to Figures 2 and 3, includes the slider 300 and the arm 90 used to move the projector between its first, operational position and its second, retracted position. The optical column 110 and the sample holder 50 have been omitted for clarity. The portion of the housing encasing the optical column 110, the sample holder 50, the projector 60 and the first detector 70 has also been omitted for clarity.

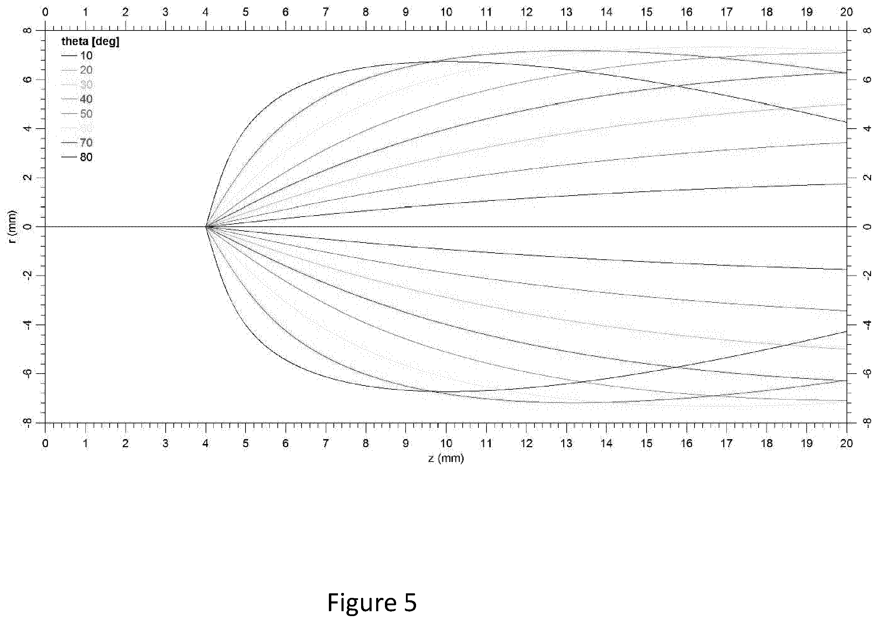

Figure 5 is a plot of distance from the optical axis (r=0 mm) against distance from the lower pole piece of the optical electron column (z=0mm) for electrons diffracted at different angles (theta) from a sample within a SEM that has a detector along the optical axis of the SEM but does not have a projector arranged along the optical axis of the SEM. Each line on the plot represents electrons diffracted at a certain angle by the sample relative to the optical axis of the SEM (theta). The paths of the electrons are determined via simulated calculations. In this specific example, the sample is positioned at z=4mm (i.e. 4 mm from the lower pole piece of the electron optical column) and the on-axis detector position starts at z= 40mm (40 mm from the lower pole piece of the electron optical column).

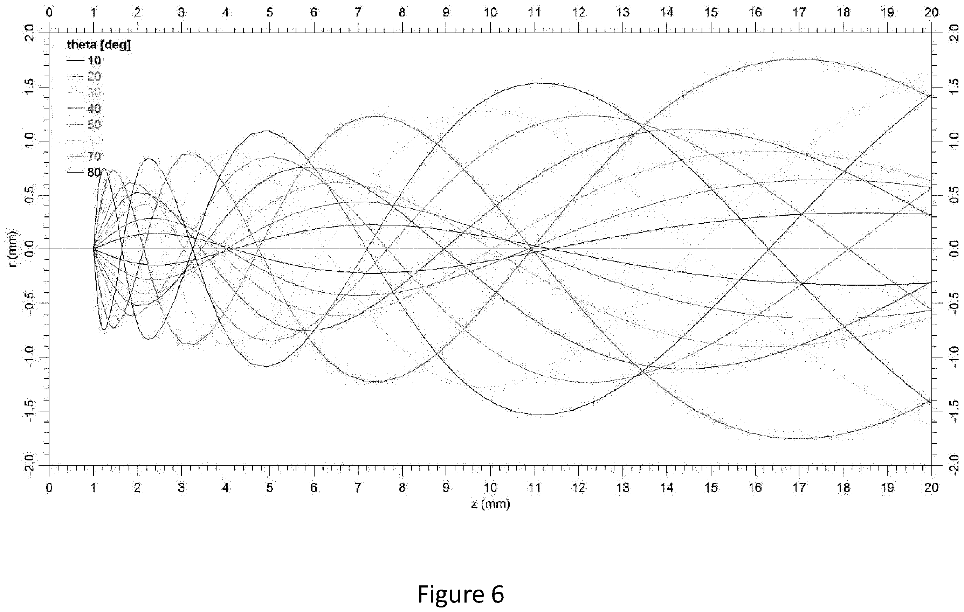

Figure 6 is a plot of distance from the optical axis (r=0 mm) against distance from the lower pole piece of the optical electron column (z=0mm) for electrons diffracted at different angles (theta) from a sample within a SEM that has a detector along the optical axis of the SEM but does not have a projector arranged along the optical axis of the SEM. Each line on the graph represents electrons diffracted at a certain angle by the sample relative to the optical axis of the SEM (theta). The paths of the electrons are determined via simulated calculations. In this specific example, the sample is positioned at z=1mm (i.e. 1mm from the lower pole piece of the electron optical column) and the on-axis detector position starts at z= 40mm (40 mm from the lower pole piece of the electron optical column). Figure 6 differs from Figure 5 in that the working distance employed is shorter (1 mm rather than 4 mm).

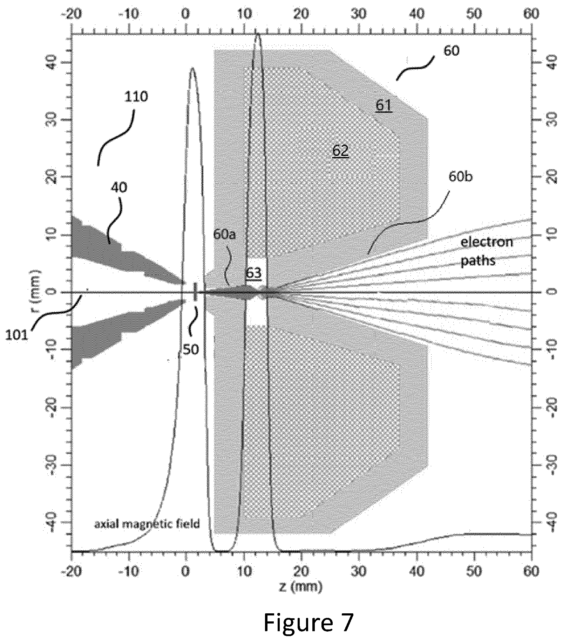

Figure 7 is a plot demonstrating the path of the electrons from the lower pole piece of the electron optical column 110 through the projector 60 to the first detector 70 when the projector 60 is in the first, operational position in the SEM 100 (i.e. along the optical axis 101 of the SEM 100) according to the claimed invention. The paths of the electrons are determined via simulated calculations. In this plot, r is the distance from the optical axis of the SEM 100 at r=0mm, z is the distance from the lower pole piece of the electron optical column 110 i.e. the distance from the downstream end of the objective 40 at z=0mm. The peaks of the axial magnetic field and the cross section of the lower pole piece of the electron optical column 110, the sample holder 40 and the projector 60 are superimposed on this plot.

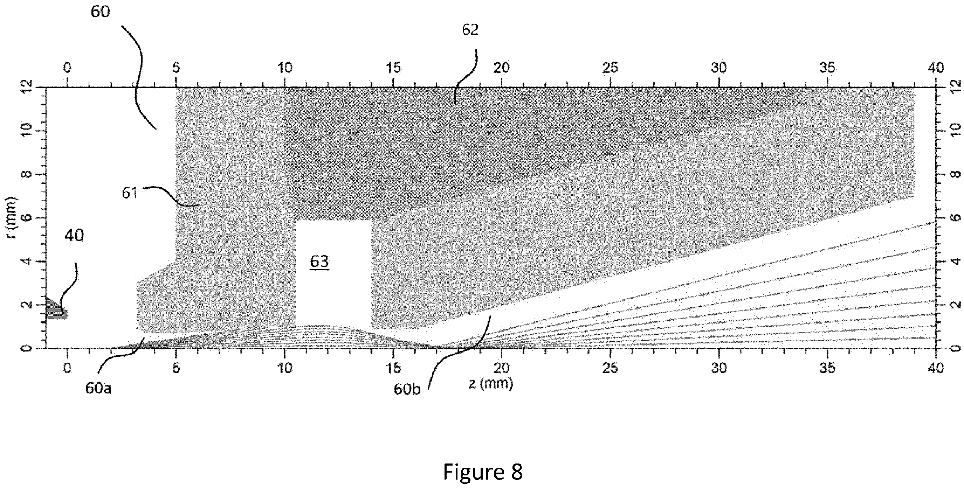

Figure 8 is a zoomed in version of part of Figure 7.

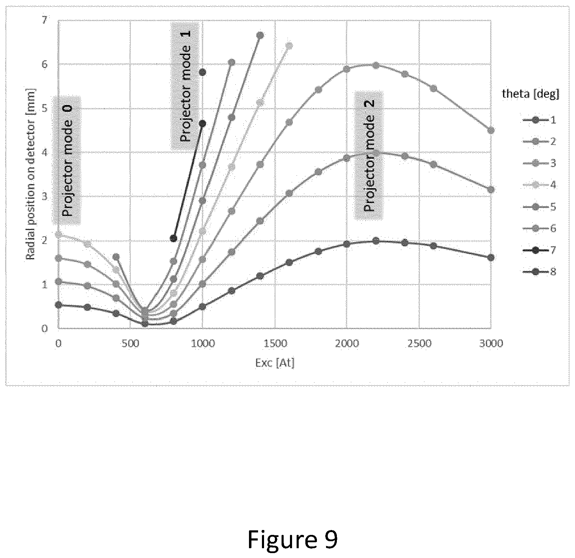

Figure 9 is a graph of projector lens coil excitation against the radial position of the electrons on the detector where the radial position is measured in mm from the optical axis of the SEM at r=0mm. Each line on the graph represents electrons diffracted at a certain angle (theta) by the sample relative to the optical axis of the SEM (theta). The paths of the electrons are determined via simulated calculations.

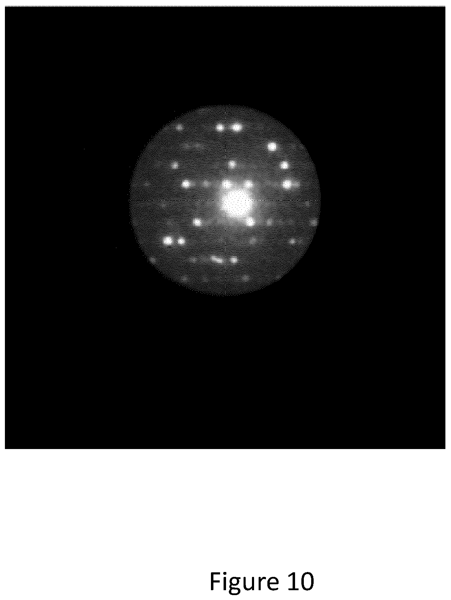

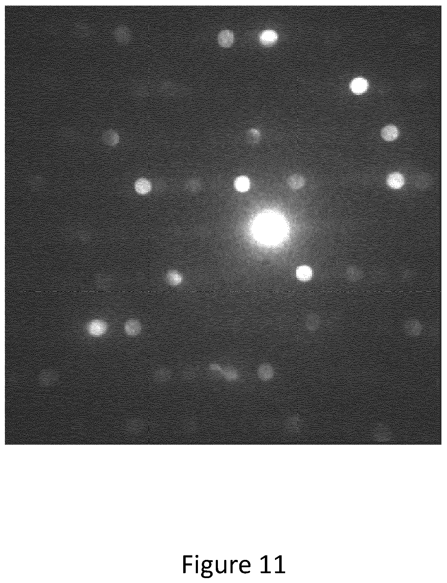

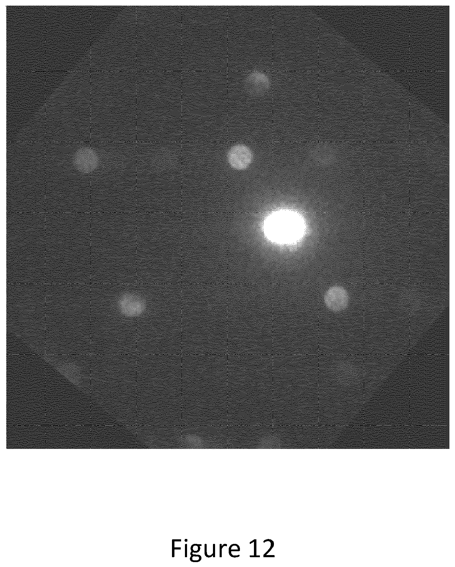

Figures 10 to 12 are exemplary diffraction images acquired using the SEM of the claimed invention with the projector 60 in the first, operational position. The diffraction images were acquired at the same SEM conditions. The diffraction images are taken of the same region of a sample. The sample was an asbestos crocidolite fiber having a thickness of approximately 100 nm. The images differ by the excitation of the projector lens coil. For Figure 10, the excitation of the projector lens coil was 0 Ampere-turns. For Figure 11, the excitation of the projector lens coil was 1600 Ampere-turns. For Figure 12, the excitation of the projector lens coil was 2500 Ampere-turns.

### Detailed Description

Figure 1 is a schematic diagram of the imaging components of the SEM 100 and of the electron path through the SEM 100 of the claimed invention. The SEM has an optical axis 101.

The SEM 100 comprises a housing 200 (as shown in Figure 2) having a first housing portion 200a defining a first chamber 201 containing an electron source 10, a condenser module 20, scanning coils 30, an objective 40, a sample holder 50, a projector 60 and a first detector 70. The first chamber 201 is under vacuum to protect these components from contamination, vibrations etc. Upstream and downstream used herein refer to the direction of the electron beam when the SEM is in use. For example, in use, the electron beam is directed from the electron source 10 towards the sample holder 50 in a downstream direction. The path of the electron beam within the SEM is schematically shown by the thinner solid lines in Figure 1.

The electron source 10 and the sample holder 50 are both arranged upon i.e. coaxial with (centred along) the optical axis of the SEM.

The electron source 10 may be, for example a Schottky electron source or ion gun. The electron source 10 produces a primary electron beam. The energy of the primary beam emitted from the electron source 10 is typically between 0.2eV and 40 keV, preferably between 0.2 eV and 30 keV. The primary beam emitted from the electron source 10 is aligned with i.e. coaxial with the optical axis 101 of the SEM 100.

Downstream of the electron source is the condenser module 20 that manipulates the primary electron beam from the electron source 10. The condenser module 20 comprises at least one condenser lens that converges the electron beam as it travels towards the sample holder 40. The condenser lens(es) are typically an electromagnetic lens(es) that use a magnetic field to control the direction of the electrons within the beam. The condenser module 20 may comprise other lenses or other particle-optical components that may perform, for example, aberration mitigation, cropping (with a stop / iris / condensing aperture), filtering, etc.

Downstream of the condenser module 20 are one or more scanning coil(s) 30 that deflect/raster the electron beam across the sample i.e. in the plane orthogonal to the optical axis as is known in the art. The scanning coil(s) 30 are controlled by a controller (not shown).

Downstream of the scanning coil(s) 30 is the objective 40. The condenser module 20, scanning coils 30 and objective 40 form the electron optical column 110 of the SEM, as is known in the art. The downstream end of the objective 40 forms the lower pole piece of the electron optical column 110. The objective 40 generates an objective lens that may be an electromagnetic lens. In particular, the objective lens may be an electromagnetic immersion lens.

The electron source 10, condenser module 20, scanning coil(s) 30 and objective 40 together form the electron optical column 110 of the SEM 100. The operation of these components within an SEM is known in the art. The electron optical column 110 may be aligned with i.e. centred with the optical axis 101 of the SEM 100. The electron optical column 110 may be mounted to an inner surface of the first portion 200a of the housing thereby fixing the electron optical column 110 in place within the first chamber 201. The downstream end of the objective 40 forms the lower pole piece of the electron optical column 110.

Downstream of the electron optical column is the sample holder 50 that supports the sample. The sample holder 50 may be tilted or rotated as controlled by a controller and by a motor coupled to the sample holder 50 (not shown) as is known in the art. The sample holder 50 is aligned with/centred with/arranged upon the optical axis 101 of the SEM 100. The optical axis 101 of the SEM 100 intersects the sample holder 50, in particular, intersects the centre of the sample holder 50. The sample holder 50 may be positioned in the first portion 200a of the housing 200 of the SEM 100. The sample holder 50 may be fixed relative to the first portion 200a of the housing 200.. The sample holder 50may remain aligned with the optical axis 101 of the SEM 100 such that the optical axis 101 intersects the sample holder despite tilt or rotation of the sample holder 50.

The SEM 100 may optionally comprise second detectors (not shown), which may be a back scattered electron detector and/or a secondary electron detector. A back scattered electron detector may be arranged upstream of the sample holder 50 between the sample holder 50 and the objective 40. Back scattered electron detectors are known in the art and are typically annular in shape and positioned concentric with the optical axis 101 of the SEM. The secondary electron detector may be arranged offset from the optical axis 101 of the SEM 100 and upstream of the sample holder 50 as is known in the art. The backscattered electron detector may be a scintillation detector or solid-state detector. The secondary electron detector may be, for example, an Everhart-Thornley detector that employs a scintillator inside a Faraday cage.

The SEM of the claimed invention differs from known SEM as it employs a projector 60 and first detector 70 downstream of the projector 60. When the projector 60 is in a first, operational position as shown in Figure 1, the projector 60 is arranged downstream of the sample holder 40 and guides transmitted electrons emanating from the sample to the first detector 70. The projector 60 has a projector optical axis that is aligned with the optical axis of the SEM when the projector 60 is in the first, operational position. The projector 60 comprises one or more projector lens(es) that magnify and project the diffraction pattern onto the first detector 70. The projector lens(es) may be electromagnetic lenses and the strength of their magnetic field may be adjusted to adjust their focal length and so the magnification. Projectors are known within TEMs for performing magnification. However, such projectors are large, heavy and comprise multiple lenses. The projector 60 in the claimed invention may advantageously employ a single projector lens that is optionally an electromagnetic lens thereby minimising weight and size. In other words, the projector 60 may consist of a single projector lens.

In an embodiment where the projector has a single projector lens, the single projector lens may be an electromagnetic multipole lens. A cross section of an example of such a projector lens is shown in Figure 7. The projector lens in this example has a shell/yoke 61 that houses a projector lens coil 62 arranged circumferentially around the projector optical axis.

As shown in this figure, the projector lens may have an upper projector pole piece 60a and a lower projector pole piece 60b separated by a gap, referred to herein as the projector gap 63. The projector gap 63 may be defined between the upper and lower projector pole pieces 60a, 60b and by the projector lens coil 62 extending circumferentially around the projector gap 63. The projector gap 63 is centred with the projector optical axis. The upper projector pole piece 60a defines a first pathway for an electron beam and the lower projector pole piece 60b defines a second pathway for the electron beam. These pathways are joined together by the projector gap 63. The projector gap 63 reduces spherical aberration and consequently improves image resolution.

The upper projector pole piece 60a and lower projector pole piece 60b are co-axial with the projector optical axis. In this exemplary embodiment, each of the upper projector pole piece and lower projector pole piece 60a, 60b are funnel-shaped with a cylindrical inlet portion upstream of a frustoconical portion. For each of the upper projector pole piece and lower projector pole piece 60a, 60b, the frustoconical portion has a wider downstream opening than upstream opening i.e. the upper projector pole piece 60a and the lower projector pole piece 60b have diameters that increase in a direction from upstream to downstream. The frustoconical portion of the lower projector pole piece 60b optionally has a greater height and/or is inclined at a greater angle than the frustoconical portion of the upper projector pole piece 60a.

In this exemplary embodiment, each of the upper projector pole piece and lower projector pole piece 60a, 60b may be defined by the walls of the yoke 61. The upstream walls of the yoke 61 may define the upper pole piece 60a and the downstream walls of the yoke 61 may define the lower pole piece 60b. The walls of the yoke 61 may be tapered to create the frustoconical shaped portions of the upper and lower pole pieces 60a, 60b.

This exemplary configuration of the projector lens in the projector 60 described is by way of example and is not intended to be limiting. Other shapes of multipole lenses and other types of lenses, such as round lenses, may be employed in the projector 60 instead.

As shown in Figure 1, the first detector 70 is downstream of the projector 60. The first detector 70 is optionally a pixelated detector and optionally controlled by the controller (not shown). The pixelated detector comprises a plurality of pixels that can detect individual electrons incident at the detector to generate a diffraction image. The pixelated detector may comprise a two-dimensional arrangement of pixels. Pixelated detectors typically make use of an array of semiconductor diodes and complementary metal-oxide-semiconductor (CMOS) technologies. These devices contain pixelated arrays of detectors (for example, typically 256 × 256 pixels, although other sizes are possible) closely coupled to an array of CMOS preamplifiers. The small capacitance of each pixel (typically having a size of only around 55µm × 55µm) and close coupling of a preamplifier to each individual pixel allows the detector to pulse count individual electrons arriving at each pixel. The large number (for instance 64,000) of independent pixels in the detector array allows an extremely high count rate to be achieved. Examples of such detectors include detectors in the MEDIPIX^{RTM} and TIMEPIX^{RTM} family. Such pixelated detectors may be referred to as active pixelated detectors.

In the embodiment of Figure 1, the projector 60 is in the first, operational position such that the optical axis of the SEM intersects both the projector 60 and the first detector 70. In particular, the projector 60 is centred with the optical axis of the SEM 100 and so centred with the sample holder 50 and the electron source 10. With the projector 60 in the first, operational position, the primary electron beam produced by the electron source is aligned with/co-axial with the optical axis of the projector 60 and the first detector 70. In use with the projector 60 in the first, operational position, the primary electron beam is generated by and emitted from the electron source 10 along the optical axis of the SEM 100, the electron beam is then focussed by the condenser module 20 and the objective lens generated by the objective 40 before being scanned over the sample in the plane orthogonal to the optical axis under the control of the scan coils 30. The electrons transmitted through the sample on the sample holder 50 then pass through the projector lens 60 and impact the first detector 70. The projector 60 magnifies the resulting diffraction pattern onto the first detector 70.

As shown by comparing Figures 2 and 3, the projector 60 is movable between the first, operational position (as shown in Figure 2), to a second, retracted position (as shown in Figure 3). The projector 60 is moveable relative to the sample holder 50, the electron source 10, the condenser module 20 and the objective 40 of the SEM 100.

In the embodiment shown in Figures 2 and 3, the first detector 70 is optionally fixed relative to the projector 60 and spaced apart from the projector 60 in a direction downstream of the projector 60, more specifically, in a direction parallel to or along the optical axis of the projector 60, referred to herein as the projector optical axis. The projector optical axis being the axis which the electron beam travels along through the projector 60, typically through the centre of the projector 60. In other words, the detector 60 is fixed downstream of the projector 60 so that electrons passing through the projector 60 impact/impinge on the first detector 70. More specifically, the first detector 70 is fixed relative to the projector 60 so that an active area of the first detector 70 configured to receive electrons thereon (in the case of a pixelated detector, the active area containing the pixels) overlaps with, and is preferably centred with, the projector optical axis. The first detector 70 is moveable with the projector 60 relative to the sample holder 50, electron source 10, condenser module 20, objective 40 and housing 200 of the SEM 100. On moving the projector 60 from the first, operational position to the second, retracted position, the first detector 70 remains in alignment with the projector 60.

As shown in Figure 3, when the projector 60 is in the second, retracted position, both the projector 60 and the first detector 70 are located away from the optical axis 101 of the SEM 100 i.e. in an off-axis position. When the projector 60 is in the second, retracted position, the projector 60 and the first detector 70 are offset from the optical axis 101 of the SEM 100 such that any electrons transmitted through the sample do not pass through the projector 60 or the first detector 70. In particular, when the projector 60 is in in the second, retracted position, the projector 60 is offset from the optical axis 101 of the SEM 100 such that there is no overlap between the sample holder 50 and the projector 60. When the projector 60 is in the second, retracted position, there is also no overlap between the sample holder 50 and the first detector 70. In use with the projector 60 in the second, retracted position and the first detector 60 fixed relative to and downstream of the projector 60, electrons transmitted through the sample do not pass through the projector 60 or the first detector 70. Indeed, neither the projector 60 nor the first detector 70 are used for imaging the sample when the projector 60 is in the second, retracted position.

When the projector 60 is in the second, retracted position such that both the projector 60 and the first detector 70 are offset from the optical axis, the first detector 70 is not used to detect electrons transmitted through the sample. Instead, thicker samples may be imaged based on secondary and back scattered electrons emanating from the sample and detected using the second detector (not shown). As discussed above, the second detector may be a BSE detector and/or a SE detector. Imaging the sample using secondary and backscattered electrons emanating from the sample may be referred to herein as normal SEM imaging mode. Therefore, by moving the projector 60 between the first, operational position and the second, retracted position (together with the first detector 70 that is fixed relative to the projector 60), the SEM can be switched from a STEM on-axis diffraction mode (scanning transmission electron microscopy on-axis diffraction mode) for thinner samples, for example having a thickness from 1 atom thick up to 1×10⁻⁷m thick to a normal SEM imaging mode for thicker samples, for example having a thickness that is only limited by the geometric constraints of the sample holder. In the normal SEM imaging mode, there is greater space along the optical axis 101 of the SEM to accommodate thicker samples, since the projector 60 and the first detector 70 are away from the optical axis.

As shown in Figures 2 and 3, the projector 60 is movable from its first, operational position (on-axis position) to its second, retracted position (off-axis position) in a plane orthogonal to the optical axis 101 of the SEM 100. In particular, the projector 60 is moveable linearly between the first, operational position and the second, retracted position.

In the embodiment shown in Figures 2 and 4, the projector 60 is optionally coupled to an arm 90 that is operable to move the projector 60 between the first, operational position and the second, retracted position. The arm 90 extends longitudinally between a first end 91 of the arm 90 and a second end 92 of the arm 90. The arm 90 may be of a fixed length and be rigid such that it does not deform in use.

The arm 90 may be configured to move linearly when moving the projector 60 between the first, operational position and the second, retracted position. The axis along which the arm extends longitudinally and along which the arm moves is referred to herein as the longitudinal axis 93 and is perpendicular to the optical axis 101 of the SEM 100. The arm 90 may be fixed relative to the projector 60 such that movement of the arm 90 along the longitudinal axis 93 moves the projector 60 along or parallel to the longitudinal axis 93 between the first, operational position and the second, retracted position. More specifically, the arm may be configured to move in a plane orthogonal to the optical axis 110 of the SEM 100. Movement of the arm 90 along the longitudinal axis 93 may be driven by an actuator (not shown).

The first end 91 of the arm 90 may be coupled to the projector 60 and the first detector 70 such that the projector 60 does not move relative to the arm 90, as shown in Figures 2 to 4. The arm may be configured to support the projector 60. The arm 90 may be configured to support both the projector and the first detector 70. The first end 91 of the arm 90 optionally holds both the projector 60 and the first detector 70 such that the first detector 70 is fixed relative to the projector 60. The first end 91 of the arm 90 optionally comprises a holder 94 configured to hold the first detector 70 and the projector 60 such that the first detector 70 is fixed relative to the projector 60. The projector 60 and the first detector 70 being fixed relative to each other means that the projector 60 and the first detector 70 do not move relative to each other. The holder 94 may employ one or more sockets or clamps for receiving and holding the projector 60 and the first detector 70. The holder 94 may hold (i.e. retain and support) the first detector 70 spaced apart from the projector 60 and downstream of the projector 60. The holder 94 may hold the first detector 70 spaced apart from the projector 60 in a direction parallel to or along the projector optical axis. In one embodiment, the projector 60 and the holder 94 may optionally be integrally formed. In such an embodiment, the first detector 70 may be attached to the holder 94, for example, using fixing means such as screws. Such an arrangement enables replacement or repair of the detector 70.

As discussed in further detail below, the arm may be thermally coupled to the projector 60 and/or the first detector 70 and configured to conduct heat away from the projector 60 and/or the first detector 70. The arm may be configured to thermally conduct heat from the first end of the arm along the length of the arm to the second end 92 of the arm 90 thereby removing heat from the projector 60 and/or the first detector 70. Optionally, as shown in Figures 2 to 4, the second end 92 of the arm 90 may comprise a cooling component 97 configured to cool the second end 92 of the arm 90 thereby generating a thermal gradient between the first end of the arm and the second end of the arm. The cooling component 97 may be a heat exchanger, heat sink, closed-loop system or other component configured to absorb or otherwise remove heat. The cooling component 96 may be an active cooling component that employs pumps or fans to drive the flow of cooling fluid therein. In particular, the cooling component 96 may be a heat exchanger that is actively cooled. The heat exchanger may be actively cooled by an actively circulated, closed-loop cooling water circuit.

Optionally, the longitudinal portion of the arm 90 extending between the first end 91 and the second end 92 of the arm 90 may be formed of one or more rods 95, as shown in Figures 2 to 4. In other words, the arm 90 may comprise first and second ends 91, 92 and one or more rod(s) 95 extending therebetween. In the embodiment shown in Figures 2 and 3, the arm 90 optionally comprises two rods 95 extending parallel to the longitudinal axis 93 and between a first end 91 and a second end 92 of the arm 90. Although two rods 95 are shown in the embodiment of Figures 1 and 2, any number of rods 95 may be employed in the arm having any cross sectional shape. Each rod 95 is rigid and of a fixed length extending parallel to the longitudinal axis 93 of the arm 90. Employing at least two rods 95 rather than a single rod 95 is advantageous for increasing heat transfer from the projector 60 and the first detector 70. Employing at least two rods 95 is also advantageous to reduce bending of the arm 90 due to the weight of the projector 60.

The rod(s) may be coupled to the first end 91 of the arm and to the second end 92 of the arm 90 in a number of ways. For example, the rod(s) 95 may be soldered to the first end 91 of the arm and to the second end 92 of the arm 90. Alternatively, or additionally, the first end 91 of the arm and the second end 92 of the arm may comprise corresponding receptacle(s) that are complementary to the respective end of the rod(s) 95. The corresponding receptacles may be, for example threaded channels. By way of a further alternative, the rod(s) 95 may be integrally formed with the first and second ends 91, 92 of the arm 90.

The second end 92 of the arm 90 may be configured to couple to a slider 300, as shown in Figures 2 to 4. More specifically, the second end 92 of the arm may be fixed relative to a part of the slider 300 such that movement of the slider 300 is transmitted to the arm 90. The slider may be configured to transmit linear movement to the arm such that the arm moves along the longitudinal axis. As discussed above, movement of the arm 90 along the longitudinal axis 93 results in movement of the projector 60 between its first, operational position and second, retracted position.

The slider 300 is optionally a linear slider. Any suitable slider that can transmit linear motion to the arm 90 may be employed. Movement of the slider 300 may be controlled by an actuator. The actuator may be a pneumatic actuator. The controller (not shown) may be configured to control operation of the actuator to move the slider such that the projector 60 moves between its first, operational position and second, retracted position. In the embodiment shown in Figures 2 and 3, the slider 300 optionally comprises a moveable carriage 310 and a track 320 where the moveable carriage 310 is moveably coupled to the track 320. The track extends longitudinally in a direction parallel to the longitudinal axis 93. The movable carriage 310 is configured to be received within the linear track 320 and move linearly relative to the linear track 320. In other words, the movable carriage 310 may be configured to move along the track in a direction parallel to the longitudinal axis. The linear track 320 may have a channel or recessed portion or grooves arranged to guide movement of the moveable carriage 310 therein. The track 320 is fixed in position (fixed relative to the housing 200 of the SEM and so fixed relative to the electron source 10 and sample holder 50 within the housing 200).

The moveable carriage 310 may be configured to be coupled to the second end 92 of the arm 90. The moveable carriage 310 may be fixed relative to the second end 92 of the arm 90 such that movement of the moveable carriage 310 is transmitted to the arm 90. The moveable carriage 310 may be fixed to the second end 92 of the arm 90 in a number of ways. The second end 92 of the arm 90 may have a mount 96 for mounting the arm 90 to the movable carriage 310 of the slider 300. In an embodiment where the arm has one or more rod(s) 95 between its first and second ends 91, 92, the mount 96 may comprise corresponding receptacles 96a for receiving and retaining the rods 95 therein. The receptacles 96a may be formed as channels extending parallel to the longitudinal axis 93.

The moveable carriage 310 may comprise a protruding portion 311 that is received within the channel of the track 320 so that movement of the moveable carriage 310 is restrained by the linear track 320. The moveable carriage 310 may comprise a supporting portion 312 that is configured to couple to the second end 92 of the arm 90. In particular, the mount 96 of the second end 92 of the arm 90 may be mounted to the supporting portion 312 of the moveable carriage 310. The supporting portion 312 may be a supporting planar surface that is parallel to the channel of the track 320. The protruding portion 311 and the supporting portion 312 of the moveable carriage 310 may be integrally formed.

The moveable carriage 310 may be retained within the track by a number of ways, for example, by employing a lip or abutment portions defining the edge of the track. As shown in Figure 4, the moveable carriage 310 may be retained within the track by coupling the moveable carriage 310 to a supporting rod 330 extending parallel to the track 320 i.e. parallel to the longitudinal axis 93. The moveable carriage 310 may have a mounting portion 313 with a throughhole therein, the throughole extending parallel to the longitudinal axis 93 i.e. parallel to the longitudinal direction of the track 320. The throughole may be configured to slidably receive the supporting rod 330 therein such that the carriage 310 is slidable along (i.e. slidable relative to) the supporting rod 3030. In such an arrangement the carriage 310 can slide along the supporting rod 330 when moving linearly along the track 320. The supporting rod 330 may be configured to support the weight of both the carriage 310 and the second end 92 of the arm 90 mounted on the carriage 310.

Movement of the moveable carriage 310 may be limited between a first position along the linear track 320 and a second position along the linear track 320 where, when the moveable 310 carriage is in the first position, the projector 60 is in the first, operational position and when the moveable carriage 310 is in the second position, the projector 60 is in the second, operational position. The movement of the moveable carriage 310 along the linear track 320 may be limited by abutment with stops (not shown) on the linear track 320 or on the supporting rod 330 between the first and second positions of the moveable carriage 310. The movable carriage 310 may be secured in place when in the first position and when in the second position.

The slider 300 may be arranged outside the first chamber 201 i.e. outside the first housing portion 200a. The first chamber 201 being the chamber enclosing the optical electron column 110, the sample holder 50, the projector 60, the first detector 70 and the second detector (where present). Similarly, the cooling component 97 (where present) may be also be arranged outside the first chamber 201 i.e. outside the first housing portion 200a. The arm may extend through port(s) 210 formed in the housing 200 such that the second end 92 of the arm 90 is positioned outside the first chamber 201 and the first end 91 of the arm 90 is positioned inside the first chamber 201. This means that space within the first chamber 201 is maximised and weight within the chamber 201 is minimised as the slider 300 and the cooling component 97 would be arranged outside the first chamber 201. This configuration also minimises contamination within the first chamber 201 where the imaging of the sample is performed. When the projector 60 is in the first, operational position or in the second, retracted position, the projector 60 and the first detector 70 would remain inside the first chamber 201 thereby maintaining these components under vacuum. The port(s) 210 may comprise a seal to seal around the part of the arm 90 extending therethrough. The seal(s) maintain the vacuum of the first chamber 201 defined by the first portion of the housing 200a despite translation of a part of the arm 90 therethrough. When the arm 90 moves along the longitudinal axis, the arm 90 may be slidably moved within the port(s) 210.

A second portion 200b of the housing 200 defining a second chamber 202 may be connected to the first portion 200a of the housing via a vacuum flange 220 thereby maintaining both the first chamber and the second chamber under vacuum. The components of the SEM 100 that are outside the first chamber 201 may be housed within the second chamber 202 i.e. the slider 300, the cooling component 97, the second end 92 of the arm and the portion of the arm extending outside the first chamber 201. The port(s) within the housing through which the arm may translate may be formed within the vacuum flange 220.

In an embodiment where the arm 90 has rod(s) 95 extending between the first and second end(s) 91, 92, the rods 95 may be received within the port(s) 210 formed in the housing 200, particularly in the vacuum flange 220. When the arm 90 is configured as a plurality of rods 95, such as two rods in Figures 2 and 3, each rod 95 may be received within a corresponding port 210 formed in the housing 200. Each port 210 may be an aperture formed in the wall of the housing 200 and sized so as to enable passage of the respective rod 95 therethrough. Each port 210 comprises a seal configured to seal around the rod 95 thereby maintaining the vacuum of the first chamber defined by the first portion 200a of the housing 200 despite translation of the rod 95 therethrough. In particular, each port 210 may be an aperture formed in the vacuum flange 220.

As discussed above, the arm 90 may be configured to thermally conduct heat away from the projector 60 and/or the first detector 70.

In an embodiment where the arm comprises one or more rod(s) 95 extending between its first and second ends, the rod(s) 95 may have conduits extending therethrough for receiving coolant therein. The rod(s) 95 may be thermally coupled to the projector 60 and the first detector 70 such that the coolant flowing therein conducts heat away from the projector 60 and the first detector 70. The rod(s) 95 may comprise or be formed of a thermally conductive material, such as copper. Each rod 95 may comprise a heatpipe extending longitudinally therethrough. For example, each heat pipe may have a wicking material on their inner surface. Each heat pipe may be formed of a conductive material, such as copper. The wicking material may be a sintered material, such as a sintered copper powder. Each heat pipe may comprise a working fluid therein as would be known in the art.

As would be apparent to the skilled person, in operation, heat received at the first end 91 of the arm due to heating of the projector 60 and/or the first detector 70 would be conducted to the heat pipe of the rod 95 and into the wicking material resulting in evaporation of the working fluid within the heat pipe forming a vapour. This vapour would then flow to the relatively cooler part of the heat pipe proximal to the second end of the arm 92 where it condenses on the wick releasing heat. The condensed liquid would flow back through the heat pipe by capillary action towards the warmer end of the heat pipe proximal to the projector 60. The heat released proximal to the second end 92 of the arm 90 may be absorbed or otherwise radiated away from the second end 92 of the arm 90 by the cooling component 97. The cooling component 97 may actively cool the second end 92 of the arm 90 thereby increasing the thermal gradient across the heat pipe within the rod 95 for more efficient heat removal from the projector 60 and/or the first detector 70.

The effect of the projector 60 on the electron beam in the SEM of the claimed invention, when the projector is in the first, operational position, will now be explained with reference to Figures 5 to 9.

Figure 5 is a plot of distance from the optical axis of the SEM (r, where r=0 mm is the optical axis) with distance from the lower pole piece of the optical electron column (z, with z=0mm is the downstream end of the objective) for electrons diffracted at different angles (theta) from a sample. For this plot, the SEM that has an on-axis detector similar to the first detector 70 described above arranged along the optical axis but does not have a projector arranged along the optical axis. Each line on the plot is symmetric about r=0mm and represents electrons diffracted at a certain angle by the sample relative to the optical axis of the SEM (theta). The electrons diffracted by the smallest angle (10 degrees) forming the line closest to r=0mm and the electrons diffracted by the largest angle forming the line furthest from r=0 mm. The paths of the electrons are determined via simulated calculations with the SEM operating in ultra-high resolution mode with an objective forming a lens that is an immersion magnetic lens and the electron paths are energy independent.

Figure 5 is useful as a comparative figure to demonstrate the effect of employing the projector 60 along the optical axis of the SEM 100. As shown in this figure, the electron beam constricts/narrows due to the immersion magnetic field with the SEM 100 operating in UHR mode. In this specific example, the sample is positioned at z=4mm (i.e. 4 mm from the lower pole piece of the electron optical column 110) and the on-axis detector position starts at z= 40mm (40 mm from the lower pole piece).

For the plot shown in Figure 5, the electron optical column is configured similarly to the electron optical column 110 described above having an objective and a condenser module. The objective employed generates an objective lens that is a magnetic immersion lens. As shown in Figure 5, the magnetic immersion lens is an immersion magnetic field. When the SEM is operating in ultra-high resolution mode (UHR mode), this immersion magnetic field is emitted from the lower magnetic pole piece of the electron optical column and immerses the sample therein. In this arrangement (i.e. in the absence of a projector 60), the downstream end of the objective acts as an upper pole piece and the portion of the housing (typically formed of an electrically conductive material such as iron) encasing the electron optical column acts as a lower pole piece of a two-poles magnetic lens. In such an arrangement, the magnetic field that exits the downstream end of the objective penetrates the gap where the sample is positioned (at z=4mm) and is contained by the portion of the housing encasing the electron optical column..

There are two peaks in the immersion magnetic field. The strongest peak in the immersion magnetic field is strong and narrow (i.e. more concentrated) and acts as an immersion lens focussing the beam onto the sample near to the lower pole piece of the electron optical column 110 (i.e. near to the objective). The weaker peak in the immersion magnetic field is wide and weak (i.e. more diffuse) and acts as a weak lens that focusses the part of the electron beam diffracted below the sample. This weaker peak acting as a weak lens is undesirable as it constricts the diffracted beam thereby decreasing the resolution of the diffracted beam on the detector.

Figure 6 differs from Figure 5 in that a smaller working distance is employed (the sample is closer to the objective). As can be seen from Figure 6, with a smaller working distance, the situation is more complex. In this specific example, the sample is positioned at z=1mm i.e. 1 mm from the downstream end of the objective and the on-axis detector position starts at z= 40 mm i.e. 40 mm from the downstream end of the objective. In this situation, there are many foci below the sample. As shown in Figure 6, the electrons within the electron beam are jumbled due to the immersion magnetic field in UHR mode.

When the projector 60 is employed and positioned in its first, operational position along the optical axis, the projector 60 controls the electron beam downstream of the sample. By using the projector 60 to control the electron beam downstream of the sample rather than relying solely on the weaker peak in the immersion magnetic field generated by the objective 40, the magnetic field focussing the beam diffracted below the sample can be tuned to move the foci close below the sample. This results in an increase in the diffraction pattern size on the first detector 70. In this embodiment of the invention, the objective 40 acts as an upper pole piece and the projector 60 acts as a lower pole piece of a two-poles magnetic lens.

Figure 7 is a plot demonstrating the path of the electrons from the sample 50 through the projector 60 when the projector 60 is in the first, operational position in the SEM 100 (i.e. along the optical axis 101 of the SEM 100) according to the claimed invention. In this figure r is the distance from the optical axis 101 of the SEM 100 at r=0mm, z is the distance from the downstream end of the objective 40 at z=0mm. The peaks of the axial magnetic field are superimposed on this plot. As can be seen in this figure, the axial magnetic field has a strong peak near to the sample at z=1mm and a strong peak near to the projector gap 63 at z=12mm. The increase in the axial magnetic field from z=32 mm is due to residual magnetic field.

The cross section of the lower pole piece of the electron optical column 110 formed by the downstream end of the objective 40, the sample holder 50 and an exemplary embodiment of the projector 60 are also superimposed on this plot. The projector starts at z=3mm and the sample is positioned at z=2mm. As can be seen in this figure, in this exemplary embodiment the projector 60 has a single lens referred to herein as the projector lens that is an electromagnetic multipole lens. As discussed in detail above, the projector lens has a shell/yoke 61 that houses the projector lens coil 62 arranged circumferentially around the projector optical axis. As discussed above, the projector 60 has upper projector pole piece 60a that is upstream of the lower projector pole piece 60b where the upper and lower projector pole pieces 60a, 60b are spaced apart by the projector gap 63.

As can be seen in Figure 7 and discussed in more detail below, the electrons are first focussed on the sample by the field acting as an immersion magnetic lens formed in the gap between the lower pole piece of the objective 40 (acting as the upper pole piece of the immersion magnetic lens) and the upper projector pole piece 60a (acting as the lower pole piece of the immersion magnetic lens). The electrons diffracted by the sample are then focussed further by the projector 60 (when the projector is in the first position and turned ON) at or proximal to the projector gap 63 before being spread out. The position at which the electrons are focussed by the projector 60 depends on the projector coil excitation where a stronger (higher) excitation results in a shorter focal distance. For example, in Figure 7, the projector coil excitation was 1600 Ampere-turns (At) resulting in focussing of the electrons at approximately z = 12 mm. In Figure 8, the projector coil excitation was 1000 At resulting in focussing of the electrons at approximately z = 17 mm.

As shown more clearly in Figure 8, which is a zoomed in version of part of Figure 7, the strong peak in the magnetic field near to the projector gap 63 (i.e. at z = 12 mm) focusses electrons having energies of 25 kV close to but downstream of the projector gap 63 at z = 17 mm so that they can reach a wider spread from the optical axis up to r = 6 mm from the optical axis on the first detector 70 positioned at approximately z = 40 mm compared to that shown in Figure 5 for electrons at the same angle (theta).

The use of the projector can result in up to 4x magnification of the diffractogram. The use of the projector can result in greater than 160 px/DS resolution (160 pixels per diffraction spots

The following is provided as an explanation as to the path of the electrons into, through and out of the projector 60, as shown in Figures 7 and 8. In use, the projector lens coil 62 wound inside the yoke 61 around the circumference of the projector optical axis has an electric current passed through it in use thereby generating a magnetic flux in the yoke 61. The magnetic field from the upper projector pole piece 60a leaks within the vacuum within the yoke 61 due to the presence of the projector gap 63. The leakage magnetic field has a curvature and acts as a lens to converge the electron beam. The strength of this can be varied by changing the electric current of the projector lens coil 62. The leakage magnetic field in the projector gap 63 between the upper and lower projector pole pieces 60a, 60b leaks into the upstream end of the lower projector pole piece 60b creating a strong magnetic lens as indicated by the peak in the axial magnetic field at z=12 mm in Figure 7. The peak in the axial magnetic field proximal to the projector gap 63 focusses the electron beam slightly below the projector gap 63 as best shown in Figure 8 before the electron beam is spread out at high angle from the optical axis on travelling through the lower pole piece 60b. The diverged (spread out) electron beam results in a magnification of the resulting diffraction pattern on the detector at z=40 mm thereby increasing its resolution.

Figure 11 is a graph of projector coil excitation against distance from the optical axis on the detector in the radial direction i.e. radial position on the detector where r=0mm is the optical axis of the SEM. Each line on the graph represents electrons diffracted at a certain angle by the sample relative to the optical axis of the SEM (theta) with the smallest angle (1 degree) forming the bottom line of the plot and the larges angle (8 degrees) forming the top line of the plot. As shown in Figure 9, when the projector 60 is switched off (labelled as mode 0 on the plot), the spread of the electrons is lower than when the projector 60 is switched on with a primary coil excitation of 2200 At (labelled as projector mode 2). Indeed, r varies from 0.5 to 2 mm in mode 0 and from 1.5 to 4.5 in mode 2. This achieves maximal magnification of the electron beam on the detector. When the projector coil excitation is 1000 At (labelled as projector mode 1), then diffracted electrons having angles of up to 8 degrees reach the detector.

There is therefore an optimum projector lens coil excitation at which the spreading of the electron beam is maximal at around 1500-2500 Ampere-turns, preferably at 2000 Ampere-turns. There are also optimal dimensions of the projector lens coil and yoke/shell to reach the optimal excitation while minimising mass and heating due to high coil current as discussed above. The optimal designs enable magnification of the electron beam diffraction by 4x with optical excitation of the projector coil.

Figures 10 to 12 are exemplary diffractograms achieved using the SEM of the claimed invention with the projector 60 in the first, operational position. The diffraction images were acquired at the same SEM conditions from the same region of a sample. The sample was an asbestos crocidolite fiber having a thickness of approximately 100 nm. Diffraction patterns are seen according to its orientation. The accelerating voltage employed was 30 kV and the electron beam current employed was several tens of pA. The images differ by the excitation of the projector lens coil that is applied, and so are increasingly more magnified. For Figure 10, the excitation of the projector lens coil was 0 Ampere-turns. For Figure 11, the excitation of the projector lens coil was 1600 Ampere-turns. For Figure 12, the excitation of the projector lens coil was 2500 Ampere-turns. As can be seen from comparison of these figures, the diffraction pattern in the figures is the same but is magnified as the excitation of the projector lens coil is increased. The diffraction images were rotated in software post-processing to remove a lens-induced image rotation between them.

It will be understood that the embodiments described above are for the purposes of illustration only and that the invention is not so limited. The skilled reader will envisage various modifications and alternatives that fall within the scope of the claims.

All of the aspects and/or features disclosed in this specification may be combined in any combination, except combinations where at least some of such features and/or steps are mutually exclusive. In particular, the preferred features of the disclosure are applicable to all aspects and embodiments of the disclosure and may be used in any combination. Likewise, features described in non-essential combinations may be used separately (not in combination).

Throughout the description and claims of this disclosure, the words "comprise", "including", "having" and "contain" and variations of the words, for example "comprising" and "comprises" or similar, mean "including but not limited to", and are not intended to (and do not) exclude other components.

The use of any and all examples, or exemplary language ("for instance", "such as", "for example" and like language) provided herein, is intended merely to better illustrate the invention and does not indicate a limitation on the scope of the invention unless otherwise claimed. No language in the specification should be construed as indicating any non- claimed element as essential to the practice of the invention.

Although the projector 60 is described as having a single lens to minimise its weight and size (i.e. only one lens), the projector 60 may alternatively have a plurality of lenses.

Although the projector lens is primarily described an electromagnetic multipole lens, other types of projector lenses such as round lens may be employed.

Although the embodiments shown in Figures 2 and 3 employ the first detector 70 fixed relative to the projector 60 such that the first detector 70 moves with the projector 60, the first detector 70 may instead be fixed in a position along the optical axis of the SEM below the sample holder 50. In such an arrangement, the projector 60 may move relative to the first detector 70 such that, when the projector 60 is in the first, operational position, the first projector 60 is between the sample holder 50 and the first detector 70 along the optical axis of the SEM. In such an arrangement, electrons transmitted through the sample may still be imaged using the first detector 70 even though the projector 60 has been retracted.

Although the embodiments shown in Figures 2 and 3 employ two rods 95 within the arm 90 that are cylindrical in cross-section, any number of rods 95 may be employed of any cross section 90.

Although the embodiment shown in Figures 2 and 3 employ an arm 90 having rods 95 and first and second ends 91, 92 that are coupled together, the rods 95 and first and second ends 91, 92 of the arm 90 may be integrally formed.

Although the embodiment shown in Figures 2 and 3 comprises a slider 300 for transmitting linear motion to the arm 90, other means of moving the arm linearly along the longitudinal axis 93 may be contemplated.

The description above relates to employing a retractable (cooled) projector 60 in a SEM 100. However, the projector 60 may equally be employed in other types of electron microscope. It will be appreciated that the teaching in respect of the projector 60 and first detector 70 above may equally be applied to such other electron microscopes but are not also set out in this section to avoid repetition.

For example, the retractable projector 60 (optionally together with the first detector 70) may be employed in a dual-beam system, such as a dual-beam FIB-SEM.

By way of further example, the retractable projector 60 (optionally together with the first detector 70) may be employed in a transmission electron microscope. More specifically, there is contemplated a transmission electron microscope comprising:
an electron source;
a sample holder for holding a sample to be analysed;
a projector; and
a first detector;
each of the electron source and the sample holder being arranged upon an optical axis of the transmission electron microscope,
characterized in that the projector is moveable between a first, operational position in which the projector is located along the optical axis downstream of the sample holder and between the sample holder and the first detector, and a second, retracted position in which the projector is located away from the optical axis.

There is also contemplated a method of imaging a sample with a transmission electron microscope, the transmission electron microscope comprising an electron source, a sample holder, a projector and a first detector, wherein the electron source and the sample holder are arranged upon an optical axis of the transmission electron microscope, the method comprising:
placing a first sample on the sample holder of the microscope;
moving the projector to a first, operational position from a second, retracted position;
   wherein in the first, operational position the projector is located along the optical axis downstream of the sample holder and between the sample holder and the first detector,
   wherein in the second, retracted position the projector is located away from the optical axis;
scanning a first electron beam generated by the electron source along the first sample to generate a first image; and
projecting the first image onto the first detector using the projector in its first, operational position;
   wherein the first image is an electron diffraction pattern formed by electrons transmitted through and diffracted by the sample.

The description of the projector and first detector described above may equally be applied to this transmission electron microscope. For example, the projector and the first detector may be coupled together such that the projector and the first detector move together between the first operational position and second retracted position, as discussed above. The transmission electron microscope may also employ one or more second detector(s) that can be used for imaging the sample when the projector and first detector are in the second retracted position.

## Claims

1. A scanning electron microscope comprising:
an electron source;
a sample holder for holding a sample to be analysed;
a projector; and
a first detector;
each of the electron source and the sample holder being arranged upon an optical axis of the scanning electron microscope,
**characterized in that** the projector is moveable between a first, operational position in which the projector is located along the optical axis downstream of the sample holder and between the sample holder and the first detector, and a second, retracted position in which the projector is located away from the optical axis.

2. The scanning electron microscope of claim 1, wherein the projector is moveable between the first, operational position and the second, retracted position in a plane orthogonal to the optical axis.

3. The scanning electron microscope of any preceding claim, wherein the projector is moveable linearly between the first, operational position and the second, retracted position.

4. The scanning electron microscope of any preceding claim, further comprising an arm operable to move the projector between the first, operational position and the second, retracted position.

5. The scanning electron microscope of claim 4, wherein the arm is configured to move linearly when moving the projector between the first, operational position and the second, retracted position, optionally wherein the scanning electron microscope further comprises a slider configured to transmit linear motion to the arm.

6. The scanning electron microscope of claim 4 or claim 5, wherein the arm extends longitudinally in a plane orthogonal to the optical axis between a first end and a second end, wherein the first end is coupled to the projector.

7. The scanning electron microscope of any one of claims 4 to 6, wherein the arm is thermally coupled to the projector and configured to cool the projector, optionally wherein the arm comprises one or more rods having cavities therein configured to receive coolant, further optionally wherein each rod comprises a heat pipe.

8. The scanning electron microscope of any preceding claim, wherein the first detector is coupled to the projector and moveable with the projector between the first, operational position and the second, retracted position.

9. The scanning electron microscope of claim 8, wherein the first detector is fixed relative to the projector and spaced apart from the projector such that the projector is between the sample holder and the first detector in the first, operational position.

10. The scanning electron microscope of any claim 8 or claim 9 when dependent on any one of claims 4 to 7 wherein the arm comprises a holder configured to hold the projector and the first detector such that the first detector is fixed relative to the projector.

11. The scanning electron microscope of claim 10 when dependent upon claim 7, wherein the arm is thermally coupled to the projector and the first detector and configured to cool the projector and the first detector.

12. The scanning electron microscope of any preceding claim, wherein the projector comprises one or more projector lens(es), optionally wherein the one or more projector lens(es) are electromagnetic lenses, further optionally wherein the one or more projector lens(es) are multipole lenses.

13. The scanning electron microscope of any preceding claim, wherein the first detector is a pixelated detector.

14. The scanning electron microscope of any preceding claim, wherein the scanning electron microscope further comprises a second detector, optionally wherein the second detector is arranged upstream from the sample holder, further optionally where the second detector is a BSE detector or a secondary electron detector.

15. A method of imaging a sample with a scanning electron microscope, the scanning electron microscope comprising an electron source, a sample holder, a projector and a first detector, wherein the electron source and the sample holder are arranged upon an optical axis of the scanning electron microscope, the method comprising:
placing a first sample on the sample holder of the microscope;
moving the projector to a first, operational position from a second, retracted position;
wherein in the first, operational position the projector is located along the optical axis downstream of the sample holder and between the sample holder and the first detector,
wherein in the second, retracted position the projector is located away from the optical axis;
scanning a first electron beam generated by the electron source along the first sample to generate a first image; and
projecting the first image onto the first detector using the projector in its first, operational position;
wherein the first image is an electron diffraction pattern formed by electrons transmitted through and diffracted by the sample.

16. The method of claim 15, wherein the scanning electron microscope further comprises a second detector, wherein the second detector is arranged upstream of the sample holder, wherein the second detector is configured to detect back scattered and/or secondary electrons emanating from the sample;
the method further comprising:
replacing the first sample with a second sample on the sample holder of the microscope;
moving the projector from the first, operational position to the second, retracted position;
scanning a second electron beam generated by the electron source along the second sample to generate back scattered and/or secondary electrons; and
receiving the back scattered and/or secondary electrons at the second detector to form an image of the second sample.
